# EUROPEAN PATENT SPECIFICATION

(11) **EP 3 796 391 B1**
(45) Date of publication and mention of the grant of the patent: **02.12.2026**
(21) Application number: 19804297.0
(22) Date of filing: 14.05.2019
(51) Int. Cl.: H10D 86/40, H10K 59/121, H10D 86/60, H10K 59/80, H10K 71/00

(54) **OLED DISPLAY SUBSTRATE AND MANUFACTURING METHOD THEREFOR, AND DISPLAY DEVICE**
OLED-ANZEIGESUBSTRAT UND HERSTELLUNGSVERFAHREN DAFÜR SOWIE ANZEIGEVORRICHTUNG
SUBSTRAT D'AFFICHAGE OLED ET SON PROCÉDÉ DE FABRICATION, ET DISPOSITIF D'AFFICHAGE

(30) Priority: 16.05.2018 CN 201810469781
(43) Date of publication of application: 24.03.2021
(73) Proprietor: BOE TECHNOLOGY GROUP CO., LTD., Beijing 100015 (CN); BEIJING BOE DISPLAY TECHNOLOGY CO., LTD., Beijing 100176 (CN)
(72) Inventor: ZHANG, Jinling, Beijing 100176 (CN); DENG, Fei, Beijing 100176 (CN)
(74) Representative: Isarpatent
(86) International application number: PCT/CN2019/086780
(87) International publication number: WO 2019/218993

(56) References cited:
- EP-A1- 3 724 918
- CN-A- 101 135 822
- CN-A- 106 057 821
- CN-A- 107 316 873
- CN-A- 108 428 730
- CN-B- 102 208 406
- JP-A- 2007 109 918
- US-A1- 2015 055 051
- US-A1- 2015 115 259
- US-A1- 2015 214 249
- US-A1- 2016 247 869
- US-B2- 9 589 995

## Description

### TECHNICAL FIELD

The present disclosure relates to the field of display technology, and in particular, relates to an OLED display substrate, a method of manufacturing the OLED display substrate, and a display device.

### BACKGROUND

An Active-Matrix Organic Light Emitting Diode (AMOLED) display has a wide market application. In the related art, a bottom-emission type Organic Light Emitting Diode (OLED) display device is mainly used for a large-size display, such as an OLED television. However, a large-size OLED display has a problem of a low aperture ratio.

US 20150214249A1 discloses an array substrate, a display device and a manufacturing method.

US 20150115259A1 discloses a display device having a high aperture ratio and including a capacitor that can increase capacitance.

### SUMMARY

An OLED display substrate, a method of manufacturing the OLED display substrate, and a display device are provided, as defined in the appended set of claims.

### BRIEF DESCRIPTION OF THE DRAWINGS

FIG. 1 is a schematic diagram of positional relationship between an aperture region and a storage capacitor in a related OLED display substrate;
FIG. 2 is a schematic diagram of a pixel structure of a related OLED display substrate;
FIG. 3 is a schematic structural diagram of a storage capacitor of an OLED display substrate in the present disclosure;
FIG. 4 is a schematic diagram of positional relationship between an aperture region and a storage capacitor in an OLED display substrate according to some embodiments of the present disclosure; and
FIG. 5 is a specific schematic structural diagram of a storage capacitor inn OLED display substrate according to some embodiments of the present disclosure.

### Reference Signs

A a storage capacitor
B an aperture region
21 a base substrate
22 a light-shielding metal layer
23 a buffer layer
24 a first capacitor electrode or an active layer
25 an interlayer insulating layer
26 a second capacitor electrode or a transparent electrode
27 a passivation layer
28 a third capacitor electrode or an anode

### DETAILED DESCRIPTION

In order to make a technical problem, a technical solution and an advantage to be solved by the present disclosure more apparent, following detailed description will be made with reference to accompanying drawings and specific embodiments. Scope of the invention is defined by the scope of the appended claims.

A related design of an OLED display substrate is that an aperture region and a storage capacitor are separated, and light cannot pass through a region where the storage capacitor is located, thereby reducing an aperture ratio of the OLED display substrate.

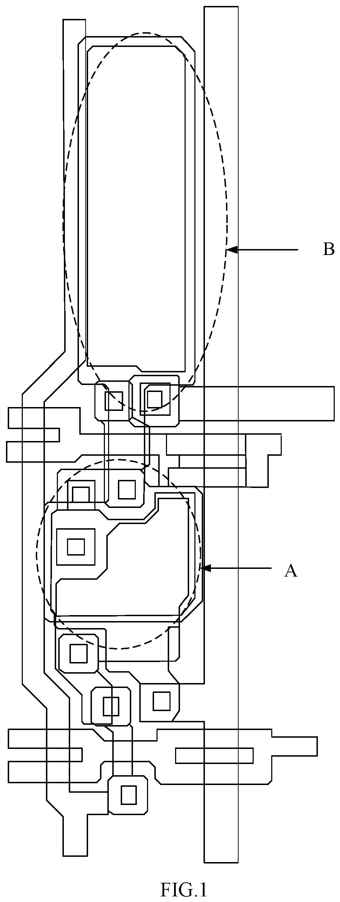

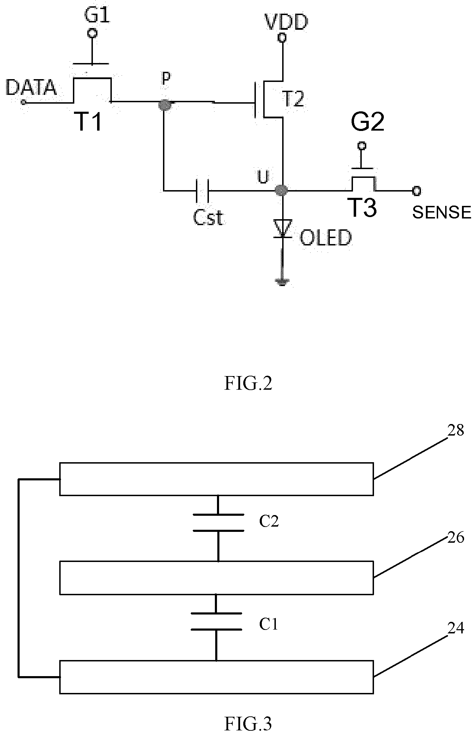

The aperture ratio of a related OLED display using a 3T1C pixel structure is approximately between 20% and 30%. FIG. 1 is a schematic diagram of positional relationship between an aperture region and a storage capacitor of a related OLED display substrate. FIG. 2 is a schematic diagram of a pixel structure of a related OLED display substrate. It may be seen that, in the related OLED display substrate, the aperture region B and the storage capacitor A are designed separately, and light cannot pass through the region where the storage capacitor is located, thereby reducing the aperture ratio of the OLED display substrate. Moreover, since the pixel structure is concentrated at a narrow space of a pixel, it is easy to cause electrical failure in a backplate manufacturing process, which is one of reasons why a product yield in production of an OLED display substrate is difficult to be improved.

In view of the above problems, some embodiments of the present disclosure provide an OLED display substrate, a method of manufacturing the OLED display substrate, and a display device, so that the aperture ratio of the OLED display substrate may be improved.

Some embodiments of the present disclosure provide an OLED display substrate. Referring to FIG. 3 to FIG. 5, the OLED display substrate includes a plurality of aperture regions B arranged in an array on a base substrate, and a plurality of storage capacitors A, wherein, an orthographic projection of each of the plurality of storage capacitors A on the base substrate 21 has an overlapping region with an orthographic projection of an aperture region corresponding to the storage capacitor in the plurality of aperture regions B on the base substrate 21.

Optionally, a light transmittance of each of the plurality of storage capacitors A is greater than a preset threshold value, for example, 80% or more, such as, 90%, 95%, etc.

In this example, the light transmittance of the storage capacitor is greater than the preset threshold value, and the orthographic projection of the storage capacitor on the base substrate and the orthographic projection of the aperture region on the base substrate are designed to have the overlapping region. In this way, an area of the storage capacitor may be increased, and an area of the aperture region of a pixel may be increased, too, so that the aperture ratio of the OLED display substrate may be improved. In addition, a space occupied by the pixel is increased, a line density is remarkably decreased, and the product yield is also improved.

An electrode of the storage capacitor may be made of a transparent conductive material. By selecting the material and a thickness of an electrode of the storage capacitor, the light transmittance of the storage capacitor may be more than 80%, so that the storage capacitor may be designed to be in the aperture region and an area of the aperture region of the pixel may be increased, thereby further increasing the aperture ratio of the OLED display substrate.

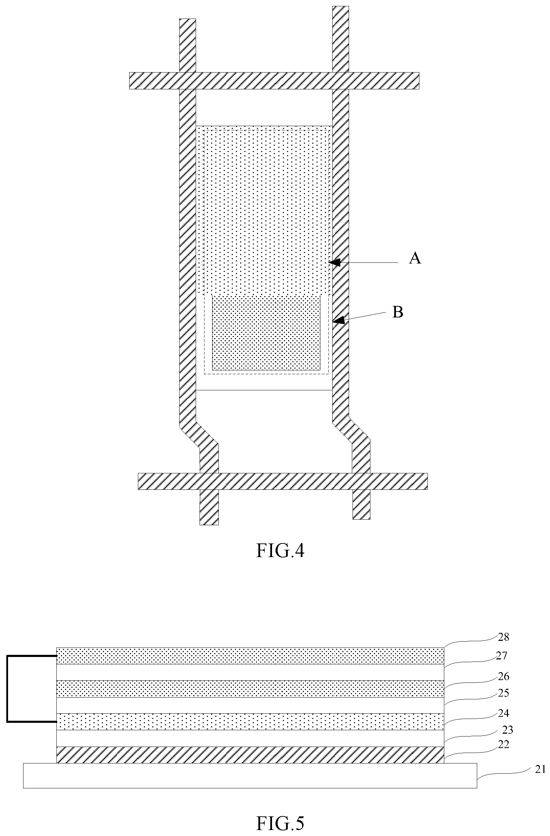

Optionally, as shown in FIG. 4, an orthographic projection of the storage capacitor A (a portion in a dashed box) on the base substrate falls within an orthographic projection of the aperture region B on the base substrate. In this way, the storage capacitor A does not occupy an area other than the aperture region B, so that the area of the aperture region may be maximized due to no requirement of an area used to accommodate the storage capacitor outside the aperture region.

Referring to FIG. 3 and FIG. 5, the storage capacitor includes a first capacitor electrode 24, a first insulating layer 25 on the first capacitor electrode 24, a second capacitor electrode 26 on the first insulating layer 25, a second insulating layer 27 on the second capacitor electrode 26, and a third capacitor electrode 28 on the second insulating layer 27, wherein the third capacitor electrode 28 is electrically connected to the first capacitor electrode 24. The first capacitor electrode 24 and the second capacitor electrode 26 provide a first capacitor Cl, the second capacitor electrode and the third capacitor electrode provide a second capacitor C2, and the two capacitors are electrically connected approximately in parallel (in parallel). Thus, a capacitance value of the storage capacitor is a sum of capacitance values of the two capacitors.

The first capacitor electrode 24 is made of an electrically-conductive active layer; the second capacitor electrode 26 is made of a transparent electrode; the third capacitor electrode 28 is made of an anode of the OLED display substrate. In this example, the storage capacitor is formed of the transparent electrode, the electrically-conductive active layer and the anode by utilizing a characteristic of a high light transmittance of the transparent electrode, and the storage capacitor is used in the aperture region of the pixel, thereby both increasing the area of the aperture region of the pixel and increasing the area of the storage capacitor, and an capacitance of the formed storage capacitor is correspondingly increased. Meanwhile, since a pixel structure is greatly simplified, a line density is remarkably reduced, which is beneficial to improvement of the product yield. In general, the anode of the OLED display substrate is also made of a transparent electrically-conductive material, so that both of the capacitor electrodes of the storage capacitor are transparent.

Optionally, the transparent electrodes may be made of one of indium tin oxide (ITO), graphene, and MoTi. Of course, a material of the transparent electrodes is not limited to the ITO, the graphene, and the MoTi, and other transparent electrically-conductive materials having a high light transmittance and an excellent electrical conductivity may be used.

Optionally, the OLED display substrate includes an interlayer insulating layer 25 between the first capacitor electrode 24 and the second capacitor electrode 26 and a passivation layer 27 between the second capacitor electrode 26 and the third capacitor electrode 28.

The OLED display substrate includes a gate insulating layer, a gate electrode, and a gate line between the first capacitor electrode 24 and the interlayer insulating layer 25.

Optionally, the OLED display substrate includes a source electrode, a drain electrode, and a data line in a same layer as that of the second capacitor electrode 26.

Optionally, the OLED display substrate includes a light-shielding metal layer 22 at a side of the first capacitor electrode 24 facing towards the base substrate 21, and a buffer layer 23 between the light-shielding metal layer 22 and the first capacitor electrode 24. The light-shielding metal layer 22 may be a metal such as Cu, Al, Ag, Mo, Cr, Nd, Ni, Mn, Ti, Ta, W, or an alloy of these metals. The buffer layer 23 may be an oxide, a nitride, or an oxynitride.

Some embodiments of the present disclosure also provide a display device including the OLED display substrate as described above. The display device may be any product or component having a display function such as a television, a display, a digital photo frame, a mobile phone, a tablet computer, and the like, wherein the display device further includes a flexible circuit board, a printed circuit board, and a backplate.

In the display device of this example, the light transmittance of the storage capacitor is greater than the preset threshold value, and the orthographic projection of the storage capacitor on the base substrate and the orthographic projection of the aperture region corresponding to the storage capacitor on the base substrate are designed to have the overlapping region. In this way, an area of the storage capacitor may be increased, and an area of the aperture region of a pixel may be increased, too, so that the aperture ratio of the OLED display substrate may be improved. In addition, a space occupied by the pixel is increased, a line density is remarkably decreased, and the product yield is also improved.

Some embodiments of the present disclosure also provide a method of manufacturing an OLED display substrate, the OLED display substrate including a plurality of aperture regions arranged in an array. The method including a step S1.

Step S1: manufacturing a plurality of storage capacitors on a base substrate, wherein an orthographic projection of each of the plurality of storage capacitors on the base substrate has an overlapping region with an orthographic projection of an aperture region corresponding to the storage capacitor in the plurality of aperture regions on the base substrate.

Optionally, a light transmittance of each of the plurality of storage capacitors A is greater than a preset threshold value, for example, 80% or more, such as, 90%, 95%, etc.

In this example, the storage capacitor having the light transmittance greater than the preset threshold value is manufactured on the base substrate, and the orthographic projection of the storage capacitor on the base substrate and the orthographic projection of the aperture region on the base substrate are designed to have the overlapping region. In this way, the area of the storage capacitor may be increased, and an area of the aperture region of a pixel may be increased, too, so that the aperture ratio of the OLED display substrate may be improved. In addition, since the space occupied by the pixel is increased, the line density is remarkably decreased, and the product yield is also improved.

An electrode of the storage capacitor may be made of a transparent electrically-conductive material, and the light transmittance of the storage capacitor may be more than 80% by selecting a material and a thickness of the electrode of the storage capacitor. In this way, the storage capacitor may be designed to be in the aperture region, so that the area of the aperture region of the pixel may be increased, thereby further improving the aperture ratio of the OLED display substrate.

Optionally, that the orthographic projection of each of the plurality of storage capacitors on the base substrate has an overlapping region with the orthographic projection of the aperture region corresponding to the storage capacitor in the plurality of aperture regions on the base substrate, specifically includes that the orthographic projection of each of the plurality of storage capacitors on the base substrate falls within the orthographic projection of the aperture region corresponding to the storage capacitor in the plurality of aperture regions on the base substrate.

In this way, the storage capacitor does not occupy an area other than the aperture region, so that the area of the aperture region may be maximized due to no requirement of an area used to accommodate the storage capacitor outside the aperture region.

In particular, manufacturing a storage capacitor includes follow substeps S11-S15.

S 11: manufacturing a first capacitor electrode.

S12: manufacturing a first insulating layer on the first capacitor electrode.

S13: manufacturing a second capacitor electrode on the first insulating layer.

S14: manufacturing a second insulating layer on the second capacitor electrode.

S15: manufacturing a third capacitor electrode on the second insulating layer, wherein the third capacitor electrode is electrically connected to the first capacitor electrode.

The first capacitor electrode and the second capacitor electrode provide a first capacitor, the second capacitor electrode and the third capacitor electrode provide a second capacitor, and the two capacitors are electrically connected approximately in parallel, so that a capacitance value of the storage capacitor is a sum of capacitance values of the two capacitors.

The substep S11 of manufacturing the first capacitor electrode includes manufacturing the first capacitor electrode by using an electrically-conductive active layer.

The substep S13 of manufacturing the second capacitor electrode on the first insulating layer includes manufacturing the second capacitor electrode by using a transparent electrically-conductive material.

The substep S15 of manufacturing the third capacitor electrode on the second insulating layer includes: using an anode of the OLED display substrate as the third capacitor electrode.

In this example, the storage capacitor is formed of the transparent electrode, the electrically-conductive active layer and the anode by utilizing the characteristic of the high light transmittance of the transparent electrode, and the storage capacitor is used in the aperture region of the pixel, thereby both increasing the area of the aperture region of the pixel and increasing the area of the storage capacitor, and an capacitance of the formed storage capacitor is correspondingly increased. Meanwhile, since a pixel structure is greatly simplified, a line density is remarkably reduced, which is beneficial to improvement of the product yield. In general, the anode of the OLED display substrate is also made of a transparent electrically-conductive material, so that both of the capacitor electrodes of the storage capacitor are transparent, and the light transmittance of the storage capacitor may be ensured to be relatively high.

The method of manufacturing the display substrate of the present disclosure will be described in detail hereinafter with reference to the drawings and specific examples. The method of manufacturing the display substrate in this example includes following steps 1-9.

Step 1: providing a base substrate 21, and forming a light-shielding metal layer 22 on the base substrate 21.

The base substrate 21 may be a glass substrate or a quartz substrate. Specifically, the light-shielding metal layer 22 having a thickness of about 500 angstroms (Å) to 4000 angstroms may be deposited on the base substrate 21 by using a method of sputtering or thermal evaporation. The light-shielding metal layer 22 may be a metal such as Cu, Al, Ag, Mo, Cr, Nd, Ni, Mn, Ti, Ta, and W, or an alloy of these metals. Since an active layer of the OLED display substrate in this example is made of a metal oxide semiconductor, and a performance of the metal oxide semiconductor is easily changed after being illuminated by light, it is necessary to form the light-shielding metal layer 22 on the base substrate 21, the light-shielding metal layer 22 may shield the active layer made of the metal oxide semiconductor from being illuminated by light.

Step 2: forming a buffer layer 23 on the based substrate 21 after the step 1.

Specifically, a Plasma Enhanced Chemical Vapor Deposition (PECVD) method may be used to deposit the buffer layer 23 on the base substrate 1 after the step 1, and the buffer layer 23 may be an oxide, a nitride, or an oxynitride.

Step 3: forming an active layer 24 on the substrate 21 after the step 2.

Specifically, IGZO having a thickness of 700 angstroms may be deposited on the base substrate 21 as the active layer 24 after the step 2. A layer of photoresist may be coated on the IGZO. The photoresist may be exposed by using a mask, so that a photoresist unreserved region and a photoresist reserved region may be formed, wherein the photoresist reserved region corresponds to a region where a pattern of the active layer 24 is located, and the photoresist unreserved region corresponds to a region other than the pattern. A development process is performed to completely remove the photoresist in the photoresist unreserved region, and a thickness of the photoresist in the photoresist reserved region is kept to be unchanged. The IGZO in the photoresist unreserved region is completely etched off by using an etching process, and the remaining photoresist is stripped off to form the pattern of the active layer 24.

Step 4: forming a gate insulating layer, a gate electrode, and a gate line on the base substrate 21 after the step 3.

In particular, the Plasma Enhanced Chemical Vapor Deposition (PECVD) method may be used to deposit a gate insulating layer having a thickness of 500 to 5000 angstroms on the base substrate 21 after the step 3, and the gate insulating layer may be made of an oxide, a nitride or an oxynitride, and a corresponding reaction gas is SiH₄, NH₃, N₂, or SiH₂Cl₂, NH₃, N₂.

A gate metal layer having a thickness of about 500 to 4000 angstroms may be deposited on the gate insulating layer by sputtering or thermal evaporation, and the gate metal layer may be a metal such as Cu, Al, Ag, Mo, Cr, Nd, Ni, Mn, Ti, Ta, W, or an alloy of these metals. The gate metal layer may have a single-layer structure or a multi-layer structure such as Cu\ Mo, Ti\Cu\Ti, Mo\Al\Mo, and the like. A layer of photoresist is coated on the gate metal layer, and the photoresist may be exposed by using a mask, so that a photoresist unreserved region and a photoresist reserved region may be formed, wherein the photoresist reserved region corresponds to regions where patterns of the gate line and the gate electrode are located, and the photoresist unreserved region corresponds to a region other than the patterns. A development process is performed to completely remove the photoresist in the photoresist unreserved region, and a thickness of the photoresist in the photoresist reserved region is kept to be unchanged. The gate metal layer in the photoresist unreserved region is completely etched off by using the etching process, and the remaining photoresist is stripped off to form patterns of the gate lines and the gate electrode.

Thereafter, the gate insulating layer is dry-etched, and the active layer 24 needing an electrically-conductive process is implanted with H ions through a via hole penetrating through the gate insulating layer, so that the active layer 24 is electrically-conductive, and the electrically-conductive active layer 24 is used as the first capacitor electrode of the storage capacitor.

Step 5: forming an interlayer insulating layer 25 on the base substrate 21 after the step 4.

In particular, the Plasma Enhance Chemical Vapor Deposition method may be employed to deposit the interlayer insulating layer 25 on the base substrate 21 after the step 4. The interlayer insulating layer 25 may be an oxide, a nitride, or an oxynitride. A via-hole penetrating through the interlayer insulating layer 25 is formed by dry-etching.

Step 6: forming a transparent electrode 26 on the base substrate 21 after the step 5.

In particular, a transparent electrically-conductive layer is formed on the base substrate 21 after step 5. The transparent electrically-conductive layer may be made of ITO, graphene, MoTi or the like. A layer of photoresist is coated on the transparent electrically-conductive layer, and the photoresist is exposed by using a mask so that a photoresist unreserved region and a photoresist reserved region are formed, wherein the photoresist reserved region corresponds to a region where a pattern of the transparent electrode 26 is located, and the photoresist unreserved region corresponds to a region other than the pattern. A development process is performed so that the photoresist in the photoresist unreserved region is completely removed, and a thickness of the photoresist in the photoresist reserved region is kept to be unchanged. The transparent electrically-conductive layer in the photoresist unreserved region is completely etched off by using an etching process, and the remaining photoresist is stripped off to form a pattern of the transparent electrode 26, wherein, the transparent electrode 26 is connected to an S electrode (i.e., a point P in FIG. 2) of a T1 transistor in a pixel structure shown in FIG. 2 and is used as the second capacitor electrode of the storage capacitor.

Step 7: forming patterns of a data line, a source electrode, and a drain electrode on the base substrate 21 after the step 6.

Specifically, a source-drain metal layer having a thickness of about 2000 to 4000 angstroms may be deposited on the base substrate 21 by magnetron sputtering, thermal evaporation, or other film forming methods after the step 6, and the source-drain metal layer may be a metal such as Cu, Al, Ag, Mo, Cr, Nd, Ni, Mn, Ti, Ta, W, or an alloy of these metals. The source-drain metal layer may have a single-layer structure or a multi-layer structure such as Cu\ Mo, Ti\Cu\Ti, Mo\Al\Mo, and the like. A layer of photoresist is coated on the source-drain metal layer, and the photoresist may be exposed by using a mask, so that a photoresist unreserved region and a photoresist reserved region may be formed, wherein the photoresist reserved region corresponds to regions where patterns of a source electrode, a drain electrode, and a data line are located, and the photoresist unreserved region corresponds to a region other than the patterns. A development process is performed to completely remove the photoresist in the photoresist unreserved region, and a thickness of the photoresist in the photoresist reserved region is kept to be unchanged. The source-drain metal layer in the photoresist unreserved region is completely etched off by using the etching process, and the remaining photoresist is stripped off to form patterns of the source drain, the drain electrode, and the data line.

Step 8: forming a passivation layer 27 on the base substrate 21 after the step 7..

Specifically, a passivation layer having a thickness of 1000 to 2000 angstroms may be deposited on the base substrate 21 by magnetron sputtering, thermal evaporation, PECVD, or other film forming methods after the step 7. The passivation layer may be formed of an oxide, a nitride or an oxynitride. In particular, a material of the passivation layer may be SiNx, SiOx, or Si(ON)x. The passivation layer may also be made of Al₂O₃. The passivation layer may be a single-layer structure or a dual-layer structure composed of silicon nitride and silicon oxide. A reaction gas corresponding to the silicon oxide may be SiH₄, N₂O. A reaction gas corresponding to the nitride or the oxynitride may be SiH₄, NH₃, N₂ or SiH₂Cl₂, NH₃, N₂. A pattern of the passivation layer 27 including a via-hole is formed by a patterning process.

Step 9: forming an anode 28 on the base substrate 21 after the step 8.

In particular, a transparent electrically-conductive layer is formed on the base substrate 21 after the step 8. The transparent electrically-conductive layer may be ITO. A layer of photoresist may be coated on the transparent electrically-conductive layer, and the photoresist is exposed by using a mask so that a photoresist unreserved region and a photoresist reserved region of the photoresist is formed, wherein the photoresist reserved region corresponds to a region where the pattern of the anode 28 is located, and the photoresist unreserved region corresponds to a region other than the pattern. A development process is performed to completely remove the photoresist in the photoresist unreserved region, and a thickness of the photoresist in the photoresist reserved region is kept to be unchanged. The transparent electrically-conductive layer in the photoresist unreserved region is completely etched off by an etching process, and the remaining photoresist is stripped off to form a pattern of the anode 28, wherein, the anode 28 is connected to the S electrode (a node U in FIG. 2) of the T2 transistor in the pixel structure shown in FIG. 2 and is used as the third capacitor electrode of the storage capacitor.

After the above steps, the storage capacitor of the OLED display substrate is manufactured, and the structure of the storage capacitor is shown in FIG. 4, wherein the electrically-conductive active layer 24, the transparent electrode 26 and the anode 28 are used as capacitor electrodes of the storage capacitor. The storage capacitor of the present example has a high light transmittance, and thus may be designed to be in the aperture region, so that the area of the aperture region of the pixel is increased, the area of the storage capacitor is increased, and the capacitance of the formed storage capacitor is correspondingly increased.

In that above solutions, the light transmittance of the storage capacitor is great than the preset threshold value, and the orthographic projection of the storage capacitor on the base substrate and the orthographic projection of the aperture region on the base substrate are designed to have the overlap region, so that the area of the storage capacitor may be increased and the area of the aperture region of the pixel is increased, so that the aperture ratio of the OLED display substrate may be improved. In addition, since the space occupied by the pixel structure is increased, the linear density is remarkably decreased, thereby facilitating improvement of the product yield.

In the method embodiments of the present disclosure, sequence numbers of the steps are not used to define an order of the steps, and variations in the order of steps obtained by those of ordinary skills in the art without paying creative effort are also within the scope of the present disclosure.

Unless otherwise defined, technical terms or scientific terms used in the present disclosure should be of a general meaning understandable by those of ordinary skills in the art to which the present disclosure pertains. Such words as 'first', 'second' and the like used in the present disclosure are not intended to denote any order, number, or importance, but merely used to distinguish different components. Similar words such as 'including' or 'include' mean that an element or item appearing before the word covers an element or item appearing after the word and equivalents thereof, without excluding other elements or items. Similar terms such as 'connection' or 'connect' are not limited to physical or mechanical connections, but may include electrical connections, whether a direct connection or an indirect connection. Such words as 'up', 'down', 'left', 'right' and the like are used only to represent a relative positional relationship, which may also change accordingly in a case that an absolute position of a described object changes.

It will be appreciated that when an element such as a layer, a film, a region or a substrate is referred to as being located 'above' or 'below' another element, the element may be located 'directly above' or 'directly above' another element, or an intermediate element may be present.

The foregoing are optional embodiments of the present disclosure. It should be noted that several modifications and refinements may be made by those of ordinary skills in the art without departing from principles of the present disclosure. These modifications and refinements should also be considered to be within the scope of the present disclosure.

## Claims

1. An Organic Light Emitting Diode (OLED) display substrate, comprising:
a plurality of aperture regions (B) of pixels arranged in an array on a base substrate (21); and
a plurality of storage capacitors (A) on the base substrate (21),
wherein an orthographic projection of each storage capacitor (A) of the plurality of storage capacitors (A) onto the base substrate (21) has an overlapping region with an orthographic projection of an aperture region (B) of a pixel corresponding to the storage capacitor (A) in the plurality of aperture regions (B) of the pixels onto the base substrate (21);
wherein the storage capacitor (A) comprises a first capacitor electrode (24), a first insulating layer on the first capacitor electrode (24), a second capacitor electrode (26) on the first insulating layer, a second insulating layer on the second capacitor electrode (26), and a third capacitor electrode (28) on the second insulating layer, and the third capacitor electrode (28) is electrically connected to the first capacitor electrode (24),
wherein the first capacitor electrode (24) is an electrically-conductive active layer; the second capacitor electrode (26) is a transparent electrode; the third capacitor electrode (28) is an anode of the OLED display substrate;
wherein the OLED display substrate further comprises: a gate insulating layer, a gate electrode, and a gate line between the first capacitor electrode (24) and the first insulating layer;
**characterized in that** an orthographic projection of a via-hole penetrating through the gate insulating layer onto the base substrate (21) overlaps an orthographic projection of the electrically-conductive active layer onto the base substrate (21);
wherein the OLED display substrate further comprises: a light-shielding metal layer (22) at a side of the first capacitor electrode (24) facing towards the base substrate (21).

2. The OLED display substrate according to claim 1, wherein a light transmittance of each of the plurality of storage capacitors (A) is greater than a preset threshold value, the orthographic projection of the each of the plurality of storage capacitors (A) onto the base substrate (21) is within the orthographic projection of the aperture region (B) of the pixel corresponding to the storage capacitor (A) onto the base substrate (21).

3. The OLED display substrate according to claim 2, wherein the transparent electrode is made of one of ITO, graphene, and MoTi.

4. The OLED display substrate according to claim 2 or 3, wherein the preset threshold value is 80% or more.

5. The OLED display substrate according to claim 3, wherein,
the first insulating layer is an interlayer insulating layer (25), and the second insulating layer is a passivation layer (27).

6. The OLED display substrate according to claim 3 or 5, further comprising:
a source electrode, a drain electrode, and a data line in a same layer as the second capacitor electrode (26).
optionally, further comprising:
a buffer layer (23) between the light-shielding metal layer (22) and the first capacitor electrode (24).

7. A display device, **characterized by** comprising:
the OLED display substrate according to any one of claims 1-6.

8. A method of manufacturing an OLED display substrate, the OLED display substrate comprising a plurality of aperture regions (B) of pixels arranged in an array on a base substrate (21), the method comprising:
manufacturing a plurality of storage capacitors (A) on the base substrate (21), an orthographic projection of each of the plurality of storage capacitors (A) onto the base substrate (21) having an overlapping region with an orthographic projection of an aperture region (B) of a pixel corresponding to the storage capacitor (A) in the plurality of aperture regions (B) of the pixels onto the base substrate (21);
wherein manufacturing the storage capacitor (A) on the base substrate (21), comprises:
manufacturing a first capacitor electrode (24) on the base substrate (21);
manufacturing a first insulating layer on the first capacitor electrode (24);
manufacturing a second capacitor electrode (26) on the first insulating layer;
manufacturing a second insulating layer on the second capacitor electrode (26);
manufacturing a third capacitor electrode (28) on the second insulating layer, wherein the third capacitor electrode (28) is electrically connected to the first capacitor electrode (24); wherein,
manufacturing the first capacitor electrode (24) comprises manufacturing the first capacitor electrode (24) by using an electrically-conductive active layer;
manufacturing the second capacitor electrode (26) comprises manufacturing the second capacitor electrode (26) by using a transparent electrically-conductive material;
manufacturing the third capacitor electrode (28) comprises using an anode of the OLED display substrate as the third capacitor electrode (28);
wherein the manufacturing the first capacitor electrode (24) by using an electrically-conductive active layer comprises:
depositing IGZO on the base substrate (21) to form an active layer;
wherein after manufacturing the first capacitor electrode (24) on the base substrate (21), before manufacturing the first insulating layer on the first capacitor electrode (24), the method further comprises:
manufacturing a gate insulating layer, a gate electrode, and a gate line on the first capacitor electrode (24);
**characterized in that** after manufacturing the gate insulating layer, the gate electrode, and the gate line on the first capacitor electrode (24), manufacturing the first capacitor electrode (24) by using the electrically-conductive active layer, comprises:
patterning the gate insulating layer to form a via-hole penetrating through the gate insulating layer;
performing ion implantation to a portion of the active layer through the via-hole to form the electrically-conducted active layer as the first capacitor electrode (24), the portion of the active layer being a portion needing an electrically-conductive processing.

9. The method of manufacturing the OLED display substrate according to claim 8, wherein manufacturing the plurality of storage capacitors (A) on the base substrate (21), the orthographic projection of each of the plurality of storage capacitors (A) onto the base substrate (21) having the overlapping region with the orthographic projection of the aperture region (B) of the pixel corresponding to the storage capacitor (A) in the plurality of aperture regions (B) of the pixels onto the base substrate (21), comprises:
manufacturing the storage capacitor (A) on the base substrate (21), the storage capacitor (A) having a light transmittance greater than a preset threshold, the orthographic projection of the storage capacitor (A) onto the base substrate (21) being within the orthographic projection of the aperture region (B) of the pixel onto the base substrate (21).

10. The method of manufacturing the OLED display substrate according to claim 8,
the transparent electrode is made of one of ITO, graphene, and MoTi.

11. The method of manufacturing the OLED display substrate according to claim 9, wherein the preset threshold value is 80% or more.

12. The method of manufacturing the OLED display substrate according to claim 8 or 10, wherein,
manufacturing a first insulating layer on the first capacitor electrode (24) comprises: manufacturing an interlayer insulating layer (25) on the first capacitor electrode (24);
manufacturing a second insulating layer on the second capacitor electrode (26) comprises: manufacturing a passivation layer (27) on the second capacitor electrode (26);
optionally,
after manufacturing the second capacitor electrode (26) on the first insulating layer, before manufacturing the second insulating layer on the second capacitor electrode (26), the method further comprises:
manufacturing a source electrode, a drain electrode, and a data line in a layer where the second capacitor electrode (26) is,
optionally,
before manufacturing the first capacitor electrode (24) on the base substrate (21), the method further comprises:
manufacturing a light-shielding metal layer (22) on the base substrate (21); and
manufacturing a buffer layer (23) on the light-shielding metal layer (22).

## Patentansprüche

1. Organic Light Emitting Diode (OLED)-Anzeige-Substrat, umfassend:
mehrere Aperturregionen (B) von Pixeln, die in einem Array auf einem Basissubstrat (21) angeordnet sind; und
mehrere Speicherkondensatoren (A) auf dem Basissubstrat (21),
wobei eine orthogonale Projektion jedes Speicherkondensators (A) der mehreren Speicherkondensatoren (A) auf das Basissubstrat (21) eine überlappende Region mit einer orthogonalen Projektion einer Aperturregion (B) eines Pixels, das dem Speicherkondensator (A) in den mehreren Aperturregionen (B) der Pixel entspricht, auf das Basissubstrat (21) aufweist;
wobei der Speicherkondensator (A) eine erste Kondensatorelektrode (24), eine erste Isolierschicht auf der ersten Kondensatorelektrode (24), eine zweite Kondensatorelektrode (26) auf der ersten Isolierschicht, eine zweite Isolierschicht auf der zweiten Kondensatorelektrode (26) und eine dritte Kondensatorelektrode (28) auf der zweiten Isolierschicht umfasst und die dritte Kondensatorelektrode (28) elektrisch mit der ersten Kondensatorelektrode (24) verbunden ist,
wobei die erste Kondensatorelektrode (24) eine elektrisch leitfähige aktive Schicht ist; die zweite Kondensatorelektrode (26) eine transparente Elektrode ist; die dritte Kondensatorelektrode (28) eine Anode des OLED-Anzeige-Substrats ist;
wobei das OLED-Anzeige-Substrat des Weiteren umfasst: eine Gate-Isolierschicht, eine Gate-Elektrode und eine Gate-Leitung zwischen der ersten Kondensatorelektrode (24) und der ersten Isolierschicht;
**dadurch gekennzeichnet, dass** eine orthogonale Projektion eines Durchkontaktierungslochs, das die Gate-Isolierschicht durchdringt, auf das Basissubstrat (21) eine orthogonale Projektion der elektrisch leitfähigen aktiven Schicht auf das Basissubstrat (21) überlappt;
wobei das OLED-Anzeige-Substrat des Weiteren umfasst: eine lichtabschirmende Metallschicht (22) an einer dem Basissubstrat (21) zugewandten Seite der ersten Kondensatorelektrode (24).

2. OLED-Anzeige-Substrat nach Anspruch 1, wobei eine Lichtdurchlässigkeit jedes der mehreren Speicherkondensatoren (A) größer ist als ein voreingestellter Schwellenwert, die orthogonale Projektion jedes der mehreren Speicherkondensatoren (A) auf das Basissubstrat (21) innerhalb der orthogonalen Projektion der Aperturregion (B) des Pixels, das dem Speicherkondensator (A) entspricht, auf das Basissubstrat (21) liegt.

3. OLED-Anzeige-Substrat nach Anspruch 2, wobei die transparente Elektrode aus einem von ITO, Graphen und MoTi hergestellt ist.

4. OLED-Anzeige-Substrat nach Anspruch 2 oder 3, wobei der voreingestellte Schwellenwert 80 % oder mehr beträgt.

5. OLED-Anzeige-Substrat nach Anspruch 3, wobei
die erste Isolierschicht eine Zwischenschichtisolierschicht (25) ist und die zweite Isolierschicht eine Passivierungsschicht (27) ist.

6. OLED-Anzeige-Substrat nach Anspruch 3 oder 5, des Weiteren umfassend:
eine Source-Elektrode, eine Drain-Elektrode und eine Datenleitung in einer selben Schicht wie die zweite Kondensatorelektrode (26).
optional des Weiteren umfassend:
eine Pufferschicht (23) zwischen der lichtabschirmenden Metallschicht (22) und der ersten Kondensatorelektrode (24).

7. Anzeigevorrichtung, **dadurch gekennzeichnet, dass** sie umfasst:
das OLED-Anzeige-Substrat nach einem der Ansprüche 1-6.

8. Verfahren zum Herstellen eines OLED-Anzeige-Substrats, wobei das OLED-Anzeige-Substrat mehrere Aperturregionen (B) von Pixeln umfasst, die in einem Array auf einem Basissubstrat (21) angeordnet sind, wobei das Verfahren umfasst:
Herstellen mehrerer Speicherkondensatoren (A) auf dem Basissubstrat (21), wobei eine orthogonale Projektion jedes der mehreren Speicherkondensatoren (A) auf das Basissubstrat (21) eine überlappende Region mit einer orthogonalen Projektion einer Aperturregion (B) eines Pixels, das dem Speicherkondensator (A) in den mehreren Aperturregionen (B) der Pixel entspricht, auf das Basissubstrat (21) aufweist;
wobei das Herstellen des Speicherkondensators (A) auf dem Basissubstrat (21) umfasst:
Herstellen einer ersten Kondensatorelektrode (24) auf dem Basissubstrat (21);
Herstellen einer ersten Isolierschicht auf der ersten Kondensatorelektrode (24);
Herstellen einer zweiten Kondensatorelektrode (26) auf der ersten Isolierschicht;
Herstellen einer zweiten Isolierschicht auf der zweiten Kondensatorelektrode (26);
Herstellen einer dritten Kondensatorelektrode (28) auf der zweiten Isolierschicht,
wobei die dritte Kondensatorelektrode (28) elektrisch mit der ersten Kondensatorelektrode (24) verbunden wird; wobei
das Herstellen der ersten Kondensatorelektrode (24) das Herstellen der ersten Kondensatorelektrode (24) unter Verwendung einer elektrisch leitfähigen aktiven Schicht umfasst;
das Herstellen der zweiten Kondensatorelektrode (26) das Herstellen der zweiten Kondensatorelektrode (26) unter Verwendung eines transparenten, elektrisch leitfähigen Materials umfasst;
das Herstellen der dritten Kondensatorelektrode (28) die Verwendung einer Anode des OLED-Anzeige-Substrats als die dritte Kondensatorelektrode (28) umfasst;
wobei das Herstellen der ersten Kondensatorelektrode (24) unter Verwendung einer elektrisch leitfähigen aktiven Schicht umfasst:
Abscheiden von IGZO auf das Basissubstrat (21), um eine aktive Schicht zu bilden;
wobei nach dem Herstellen der ersten Kondensatorelektrode (24) auf dem Basissubstrat (21) und vor dem Herstellen der ersten Isolierschicht auf der ersten Kondensatorelektrode (24) das Verfahren des Weiteren umfasst:
Herstellen einer Gate-Isolierschicht, einer Gate-Elektrode und einer Gate-Leitung auf der ersten Kondensatorelektrode (24);
**dadurch gekennzeichnet, dass** nach dem Herstellen der Gate-Isolierschicht, der Gate-Elektrode und der Gate-Leitung auf der ersten Kondensatorelektrode (24) das Herstellen der ersten Kondensatorelektrode (24) unter Verwendung der elektrisch leitfähigen aktiven Schicht umfasst:
Strukturieren der Gate-Isolierschicht, um ein Durchkontaktierungsloch zu bilden, das die Gate-Isolierschicht durchdringt;
Durchführen einer Ionenimplantation in einen Abschnitt der aktiven Schicht durch das Durchkontaktierungsloch hindurch, um die elektrisch leitfähige aktive Schicht als die erste Kondensatorelektrode (24) zu bilden, wobei der Abschnitt der aktiven Schicht ein Abschnitt ist, der eine elektrisch leitfähige Verarbeitung erfordert.

9. Verfahren zum Herstellen des OLED-Anzeige-Substrats nach Anspruch 8, wobei das Herstellen der mehreren Speicherkondensatoren (A) auf dem Basissubstrat (21), wobei die orthogonale Projektion jedes der mehreren Speicherkondensatoren (A) auf das Basissubstrat (21) die überlappende Region mit der orthogonalen Projektion der Aperturregion (B) des Pixels, das dem Speicherkondensator (A) in den mehreren Aperturregionen (B) der Pixel entspricht, auf das Basissubstrat (21) aufweist, umfasst:
Herstellen des Speicherkondensators (A) auf dem Basissubstrat (21), wobei der Speicherkondensator (A) eine Lichtdurchlässigkeit aufweist, die größer ist als ein voreingestellter Schwellenwert, wobei die orthogonale Projektion des Speicherkondensators (A) auf das Basissubstrat (21) innerhalb der orthogonalen Projektion der Aperturregion (B) des Pixels auf das Basissubstrat (21) liegt.

10. Verfahren zum Herstellen des OLED-Anzeige-Substrats nach Anspruch 8,
wobei die transparente Elektrode aus einem von ITO, Graphen und MoTi hergestellt ist.

11. Verfahren zum Herstellen des OLED-Anzeige-Substrats nach Anspruch 9, wobei der voreingestellte Schwellenwert 80 % oder mehr beträgt.

12. Verfahren zum Herstellen des OLED-Anzeige-Substrats nach Anspruch 8 oder 10, wobei
das Herstellen einer ersten Isolierschicht auf der ersten Kondensatorelektrode (24) umfasst: Herstellen einer Zwischenschichtisolierschicht (25) auf der ersten Kondensatorelektrode (24);
das Herstellen einer zweiten Isolierschicht auf der zweiten Kondensatorelektrode (26) umfasst: Herstellen einer Passivierungsschicht (27) auf der zweiten Kondensatorelektrode (26);
optional,
nach dem Herstellen der zweiten Kondensatorelektrode (26) auf der ersten Isolierschicht, vor dem Herstellen der zweiten Isolierschicht auf der zweiten Kondensatorelektrode (26), das Verfahren des Weiteren umfasst:
Herstellen einer Source-Elektrode, einer Drain-Elektrode und einer Datenleitung in einer Schicht, wo sich die zweite Kondensatorelektrode (26) befindet,
optional,
vor dem Herstellen der ersten Kondensatorelektrode (24) auf dem Basissubstrat (21), das Verfahren des Weiteren umfasst:
Herstellen einer lichtabschirmenden Metallschicht (22) auf dem Basissubstrat (21); und
Herstellen einer Pufferschicht (23) auf der lichtabschirmenden Metallschicht (22).

## Revendications

1. Substrat d'affichage à diodes électroluminescentes organiques (OLED), comprenant :
une pluralité de régions d'ouverture (B) de pixels disposées en matrice sur un substrat de base (21) ; et
une pluralité de condensateurs de stockage (A) sur le substrat de base (21),
dans lequel une projection orthographique de chaque condensateur de stockage (A) de la pluralité de condensateurs de stockage (A) sur le substrat de base (21) présente une région de chevauchement avec une projection orthographique d'une région d'ouverture (B) d'un pixel correspondant au condensateur de stockage (A) dans la pluralité de régions d'ouverture (B) des pixels sur le substrat de base (21) ;
dans lequel le condensateur de stockage (A) comprend une première électrode de condensateur (24), une première couche isolante sur la première électrode de condensateur (24), une seconde électrode de condensateur (26) sur la première couche isolante, une seconde couche isolante sur la deuxième électrode de condensateur (26), et une troisième électrode de condensateur (28) sur la seconde couche isolante, et la troisième électrode de condensateur (28) est reliée électriquement à la première électrode de condensateur (24),
dans lequel la première électrode de condensateur (24) est une couche active électriquement conductrice ; la deuxième électrode de condensateur (26) est une électrode transparente ; la troisième électrode de condensateur (28) est une anode du substrat d'affichage OLED ;
dans lequel le substrat d'affichage OLED comprend en outre : une couche isolante de grille, une électrode de grille, et une ligne de grille entre la première électrode de condensateur (24) et la première couche isolante ;
**caractérisé en ce qu'**une projection orthographique d'un trou d'interconnexion pénétrant à travers la couche isolante de grille sur le substrat de base (21) chevauche une projection orthographique de la couche active électriquement conductrice sur le substrat de base (21) ;
dans lequel le substrat d'affichage OLED comprend en outre : une couche métallique de protection contre la lumière (22) sur un côté de la première électrode de condensateur (24) tourné vers le substrat de base.

2. Substrat d'affichage OLED selon la revendication 1, dans lequel une transmittance lumineuse de chacun de la pluralité de condensateurs de stockage (A) est supérieure à une valeur seuil prédéfinie, la projection orthographique de chacun de la pluralité de condensateurs de stockage (A) sur le substrat de base (21) se situe à l'intérieur de la projection orthographique de la région d'ouverture (B) du pixel correspondant au condensateur de stockage (A) sur le substrat de base (21).

3. Substrat d'affichage OLED selon la revendication 2, dans lequel l'électrode transparente est constituée de l'un parmi ITO, graphène, et MoTi.

4. Substrat d'affichage OLED selon la revendication 2 ou 3, dans lequel la valeur seuil prédéfinie est de 80 % ou plus.

5. Substrat d'affichage OLED selon la revendication 3, dans lequel :
la première couche isolante est une couche isolante intercouche (25), et la seconde couche isolante est une couche de passivation (27).

6. Substrat d'affichage OLED selon la revendication 3 ou 5, comprenant en outre :
une électrode de source, une électrode de drain, et une ligne de données dans une même couche que la deuxième électrode de condensateur (26).
comprenant en outre, éventuellement :
une couche tampon (23) entre la couche métallique de protection contre la lumière (22) et la première électrode de condensateur (24).

7. Dispositif d'affichage, **caractérisé en ce qu'**il comprend :
le substrat d'affichage OLED selon l'une quelconque des revendications 1 à 6.

8. Procédé de fabrication d'un substrat d'affichage OLED, ledit substrat d'affichage OLED comprenant une pluralité de régions d'ouverture (B) de pixels disposées en matrice sur un substrat de base (21), le procédé comprenant les étapes comprenant :
la fabrication d'une pluralité de condensateurs de stockage (A) sur le substrat de base (21), une projection orthographique de chacun de la pluralité de condensateurs de stockage (A) sur le substrat de base (21) présentant une région de chevauchement avec une projection orthographique d'une région d'ouverture (B) d'un pixel correspondant au condensateur de stockage (A) dans la pluralité de régions d'ouverture (B) des pixels sur le substrat de base (21) ;
dans lequel la fabrication du condensateur de stockage (A) sur le substrat de base (21) comprend :
la fabrication d'une première électrode de condensateur (24) sur le substrat de base (21) ;
la fabrication d'une première couche isolante sur la première électrode de condensateur (24) ;
la fabrication d'une deuxième électrode de condensateur (26) sur la première couche isolante ;
la fabrication d'une seconde couche isolante sur la deuxième électrode de condensateur (26) ;
la fabrication d'une troisième électrode de condensateur (28) sur la seconde couche isolante, dans lequel la troisième électrode de condensateur (28) est reliée électriquement à la première électrode de condensateur (24) ; dans lequel,
la fabrication de la première électrode de condensateur (24) comprend la fabrication de ladite première électrode de condensateur (24) à l'aide d'une couche active électriquement conductrice ;
la fabrication de la deuxième électrode de condensateur (26) comprend la fabrication de ladite deuxième électrode de condensateur (26) à l'aide d'un matériau transparent et électriquement conducteur ;
la fabrication de la troisième électrode de condensateur (28) comprend l'utilisation d'une anode du substrat d'affichage OLED comme troisième électrode de condensateur (28) ;
dans lequel la fabrication de la première électrode de condensateur (24) à l'aide d'une couche active électriquement conductrice comprend :
le dépôt d'IGZO sur le substrat de base (21) pour former une couche active ;
dans lequel, après la fabrication de la première électrode de condensateur (24) sur le substrat de base (21), avant la fabrication de la première couche isolante sur la première électrode de condensateur (24), le procédé comprend en outre :
la fabrication d'une couche isolante de grille, d'une électrode de grille, et d'une ligne de grille sur la première électrode de condensateur (24) ;
**caractérisé en ce qu'**après la fabrication de la couche isolante de grille, de l'électrode de grille, et de la ligne de grille sur la première électrode de condensateur (24), la fabrication de la première électrode de condensateur (24) à l'aide de la couche active électriquement conductrice comprend :
la structuration de la couche isolante de grille pour former un trou d'interconnexion pénétrant à travers la couche isolante de grille ;
le fait d'effectuer une implantation ionique sur une partie de la couche active à travers le trou d'interconnexion pour former la couche active électriquement conductrice servant de première électrode de condensateur (24), la partie de la couche active étant une partie nécessitant un traitement de conductivité électrique.

9. Procédé de fabrication du substrat d'affichage OLED selon la revendication 8, dans lequel la fabrication de la pluralité de condensateurs de stockage (A) sur le substrat de base (21), la projection orthographique de chacun de la pluralité de condensateurs de stockage (A) sur le substrat de base (21) présentant une région de chevauchement avec la projection orthographique de la région d'ouverture (B) du pixel correspondant au condensateur de stockage (A) dans la pluralité de régions d'ouverture (B) des pixels sur le substrat de base (21), comprend :
la fabrication du condensateur de stockage (A) sur le substrat de base (21), le condensateur de stockage (A) présentant une transmittance lumineuse supérieure à un seuil prédéfini, la projection orthographique du condensateur de stockage (A) sur le substrat de base (21) étant située à l'intérieur de la projection orthographique de la région d'ouverture (B) du pixel sur le substrat de base (21).

10. Procédé de fabrication du substrat d'affichage OLED selon la revendication 8,
l'électrode transparente est constituée de l'un parmi ITO, graphène, et MoTi.

11. Procédé de fabrication du substrat d'affichage OLED selon la revendication 9, dans lequel la valeur seuil prédéfinie est de 80 % ou plus.

12. Procédé de fabrication du substrat d'affichage OLED selon la revendication 8 ou 10, dans lequel :
la fabrication d'une première couche isolante sur la première électrode de condensateur (24) comprend :
la fabrication d'une couche isolante intermédiaire (25) sur la première électrode de condensateur (24) ;
la fabrication d'une seconde couche isolante sur la deuxième électrode de condensateur (26) comprend : la fabrication d'une couche de passivation (27) sur la deuxième électrode de condensateur (26) ;
éventuellement,
après la fabrication de la deuxième électrode de condensateur (26) sur la première couche isolante, et avant la fabrication de la seconde couche isolante sur la deuxième électrode de condensateur (26), le procédé comprend en outre :
la fabrication d'une électrode de source, d'une électrode de drain, et d'une ligne de données dans une couche où se trouve la deuxième électrode de condensateur (26),
éventuellement,
avant la fabrication de la première électrode de condensateur (24) sur le substrat de base (21), le procédé comprend en outre :
la fabrication d'une couche métallique de protection contre la lumière (22) sur le substrat de base (21) ; et
la fabrication d'une couche tampon (23) sur la couche métallique de protection contre la lumière (22).
